# EUROPÄISCHE PATENTSCHRIFT

(11) **EP 0 360 036 B1**
(45) Veröffentlichungstag und Bekanntmachung des Hinweises auf die Patenterteilung: **01.06.1994**
(21) Anmeldenummer: 89115841.2
(22) Anmeldetag: 28.08.1989
(51) Int. Cl.: H01L 29/06

(54) **Planarer pn-Übergang hoher Spannungsfestigkeit**
Planar pn-junction having a high withstand voltage
Jonction pn plane à tenue en tension élévée

(30) Priorität: 20.09.1988 DE 3831941
(43) Veröffentlichungstag der Anmeldung: 28.03.1990
(73) Patentinhaber: SIEMENS AKTIENGESELLSCHAFT, 80333 München (DE)
(72) Erfinder: Stengl, Reinhard, Dr., D-8901 Stadtbergen (DE)

(56) Entgegenhaltungen:
- US-A- 3 763 406
- IEEE ELECTRON DEVICE LETTERS, Band EDL-6, Nr. 11, November 1985, Seiten 600-601; H. YILMAZ et al.: "Floating Metal Rings (FMR), A Novel High-Voltage Blocking Technique"
- I.E.E.E. TRANSACTIONS ON ELECTRON DEVICES, Band ED-33, Nr. 3, März 1986, Seiten 426-428; R. STENGL et al.: "Variation of Lateral Doping as a Field Terminator for High-Voltage Power Devices"

## Beschreibung

Die Erfindung bezieht sich auf einen planaren pn-Übergang hoher Spannungsfestigkeit nach dem Oberbegriff des Patentanspruchs 1.

Ein planarer pn-Übergang dieser Art ist aus dem Jap. Journal of Appl. Physics, Vol. 21 (1982) Suppl. 21-1, S. 97-101 bekannt. Hierbei kontaktieren die Feldplatten in unmittelbarer Nähe ihrer inneren, d.h. dem Halbleitergebiet zugewandten, Ränder den Halbleiterkörper. Der Halbleiterkörper ist zusätzlich mit einer der Anzahl der Feldplatten entsprechenden Anzahl von Feldringen versehen, die aus ringförmigen Halbleiterzonen bestehen, welche denselben Leitfähigkeitstyp aufweisen wie das durch den pn-Übergang begrenzte Halbleitergebiet. Die Feldringe umgeben das Halbleitergebiet in jeweils ansteigender Entfernung vom Rand des pn-Übergangs. Jede einzelne der Feldplatten kontaktiert einen ihr zugeordneten Feldring, so daß dieser das Potential der Feldplatte bestimmt. Zwischen dem Halbleitergebiet und dem innersten Feldring sowie zwischen den einzelnen Feldringen befinden sich Teilzonen des schwach dotierten Halbleiterkörpers, die eine zum Halbleitergebiet entgegengesetzte Leitfähigkeit aufweisend und sich bis zu der den planaren pn-Übergang enthaltenden Grenzfläche erstrecken. Die Feldplatten bewirken gemeinsam mit den Feldringen, daß der pn-Übergang beim Anlegen einer ihn sperrenden Spannung, die über zwei das Halbleitergebiet und den Halbleiterkörper jeweils kontaktierende Elektroden zugeführt wird, in seinem planaren Randbereich eine hohe Durchbruchspannung aufweist. Diese Durchbruchspannung entspricht etwa seiner Volumensdurchbruchspannung, die als diejenige Spannung definiert ist, bei der der pn-Übergang in seinem parallel zur Grenzfläche des Halbleiterkörpers verlaufenden Teil, also im Volumen des Halbleiterkörpers, durchbricht.

Bei dieser bekannten pn-Struktur ist es jedoch nachteilig, daß die Feldplatten und Feldringe, die zum Erzielen einer hohen Durchbruchspannung notwendig sind, einen relativ großen Teil der an den Rand des pn-Übergangs angrenzenden Halbleiterfläche benötigen.

Der Erfindung liegt die Aufgabe zugrunde, einen planaren pn-Übergang der eingangs genannten Art anzugeben, der für eine gewünschte hohe Durchbruchspannung auf einer wesentlich kleineren Halbleiterfläche realisiert werden kann, als das bei dem bekannten pn-Übergang der Fall ist. Das wird erfindungsgemäß durch eine Ausbildung nach dem kennzeichnenden Teil des Patentanspruchs 1, erreicht.

Der mit der Erfindung erzielbare Vorteil liegt insbesondere darin, daß der pn-Übergang auf einer relativ kleinen Halbleiterfläche realisierbar ist, wobei jedoch für seinen planaren Randbereich ein hoher Wert der Durchbruchspannung erreicht wird, der etwa der Volumensdurchbruchspannung entspricht. Weiterhin ist der Wert der Durchbruchspannung im Randbereich von dem Wert der Dotierungskonzentration des Halbleiterkörpers unabhängig, da die Feldplatten jeweils Teile der das Halbleitergebiet in lateraler Richtung verlängernden Halbleiterzone überdecken, die den gleichen Leitfähigkeitstyp aufweisen wie das Halbleitergebiet. Im Gegensatz hierzu überdecken die Feldplatten des oben erwähnten, bekannten pn-Übergangs Teilzonen des Halbleiterkörpers, die schwach dotiert sind und einen zum Halbleitergebiet entgegengesetzten Leitfähigkeitstyp aufweisen.

Die Ansprüche 2 und 3 sind auf bevorzugte Ausgestaltungen und Weiterbildungen der Erfindung gerichtet.

Die Erfindung wird nachfolgend anhand der Zeichnung näher erläutert. Dabei zeigt:
- Fig. 1: einen Querschnitt durch den Randbereich eines planaren pn-Übergangs nach der Erfindung,
- Fig. 2: einen Querschnitt durch den Randbereich eines erfindungsgemäßen planaren pn-Übergangs zwischen der p-Basis und der n-Basis eines Thyristors,
- Fig. 3: einen Querschnitt durch den Randbereich eines anderen erfindungsgemäßen planaren pn-Übergangs, und
- Fig. 4: eine Variante des pn-Übergangs nach Fig. 1.

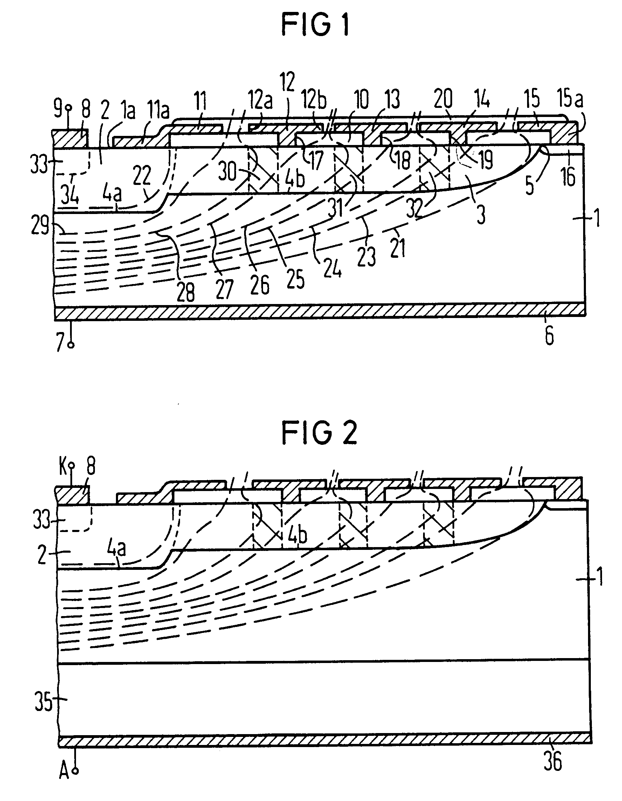

In Fig. 1 ist ein Halbleiterkörper 1, z.B. aus n-dotiertem Silizium mit einer Dotierungskonzentration von 10¹⁴cm⁻³ dargestellt, in den ein p-leitendes Halbleitergebiet 2 eingefügt ist. Dieses weist an der Grenzfläche 1a von 1 etwa eine Dotierungskonzentration von 10¹⁸cm⁻³ auf. Das Halbleitergebiet 2 wird in lateraler Richtung durch eine p-dotierte Halbleiterzone 3 verlängert, deren Dotierungsgrad z.B. 10¹⁶cm⁻³ beträgt und somit wesentlich niedriger ist als der des Halbleitergebiets 2. Das Halbleitergebiet 2 und die Halbleiterzone 3 werden durch einen pn-Übergang 4a, 4b vom übrigen Teil des Halbleiterkörpers 1 getrennt. Während das Teil 4a des pn-Übergangs im wesentlichen parallel zur Grenzfläche 1a des Halbleiterkörpers 1 verläuft, nähert sich das Teil 4b mit steigender Entfernung vom Rand des Halbleitergebiets 2 allmählich der Grenzfläche 1a an und erreicht diese bei 5. Die p-leitenden Teile 2 und 3 und der unterhalb des pn-Übergangs 4a, 4b liegende n-leitende Teil des Halbleiterkörpers 1 stellen z.B. eine Halbleiterdiode dar, wobei der Halbleiterkörper 1 an seiner Unterseite mit einer anodenseitigen Elektrode 6 versehen ist, die einen Anodenanschluß 7 aufweist, und das Gebiet 2 sowie die mit diesem zusammenhängende Halbleiterzone 3 von einer kathodenseitigen Elektrode 8 kontaktiert werden, die mit einem Kathodenanschluß 9 verbunden ist.

Die Halbleiterzone 3 kann zweckmäßigerweise nach einem Verfahren hergestellt werden, das in der EP-A-0 176 778 eingehend beschrieben ist. Ein anderes Verfahren zur Herstellung dieser Halbleiterzone kann den IEEE Transactions on Electron Devices, ED-30 (1983), S. 954 entnommen werden.

Oberhalb der Halbleiterzone 3 wird auf der Grenzfläche 1a eine elektrisch isolierende Schicht 10 aufgebracht, die z.B. eine Schichtdicke von 10 µm aufweist. Auf der Schicht 10 sind Feldplatten 11 bis 15 aus elektrisch leitendem Material, z.B. Al oder hochdotiertem polykristallinen Silizium, angeordnet, von denen die mit 11 bezeichnete, innerste Feldplatte unmittelbar im Randbereich des Halbleitergebiets 2 liegt und dieses mit ihrem inneren Plattenrand 11a kontaktiert. Die Feldplatten 12, 13, 14 und 15 weisen in dieser Reihenfolge jeweils ansteigende Abstände vom Halbleitergebiet 2 auf, wobei die äußerste Feldplatte 15 mit ihrem rechten, also äußeren Plattenrand 15a den Halbleiterkörper 1 außerhalb des Randes 5 des pn-Übergangs 4a, 4b kontaktiert. Zweckmäßigerweise ist in den Halbleiterkörper 1 eine n-leitende Kontaktzone 16 eingefügt, die z.B. eine Dotierungskonzentration von 10¹⁸cm⁻³ aufweist und ausgehend von dem außerhalb der Begrenzung 5 des pn-Übergangs 4a, 4b liegenden Teil der Grenzfläche 1a sich geringfügig in den Halbleiterkörper hinein erstreckt. Die Feldplatte 15 kontaktiert dann die Kontaktzone 16. Die Feldplatten 12, 13 und 14 kontaktieren jeweils im Bereich von Kontaktlöchern 17, 18 und 19 die p-leitende Halbleiterzone 3. Dabei ist das Kontaktloch 17 so angeordnet, daß es gleiche Abstände vom inneren Plattenrand 12a und vom äußeren Plattenrand 12b der Feldplatte 12 hat. Auch die Kontaktlöcher 18 und 19 sind so angeordnet, daß sie von den inneren und äußeren Rändern der ihnen zugeordneten Feldplatten 13 und 14 jeweils gleiche Abstände aufweisen. Die Feldplatten 11 bis 15 sind jeweils so dicht nebeneinander angeordnet, daß sie nur schmale Spalte zwischen sich freilassen, die z.B. 10 µm betragen. Die gesamte Feldplattenanordnung 11 bis 15 kann durch eine Isolierschicht 20 abgedeckt werden, die zur Passivierung dient. Sie besteht beispielsweise aus amorphem Silizium oder Kautschuk.

Legt man an den Anschluß 7 eine Spannung U hinreichender Größe, während sich der Anschluß 9 auf Massepotential befindet, so baut sich an dem in Sperrrichtung vorgespannnten pn-Übergang 4a, 4b eine Raumladungszone auf, deren unterer Rand durch die gestrichelte Linie 21 und deren oberer Rand durch die innerhalb des Gebiets 2 liegende gestrichelte Linie 22 gegeben ist. Dabei stellt 21 gleichzeitig eine Äquipotentiallinie dar, die dem Spannungswert U entspricht, während 22 eine Äquipotentiallinie bedeutet, die dem Massepotential entspricht. Die zwischen 21 und 22 befindlichen, gestrichelten Linien 23 bis 29 stellen dann jeweils weitere Äquipotentiallinien für gegeneinander abgestufte Spannungszwischenwerte dar, wobei 23 z.B. einen Potentialwert kennzeichnet, der sich nur geringfügig von U unterscheidet, während die auf der Linie 29 liegenden Punkte ein sich nur wenig vom Massepotential unterscheidendes Potential aufweisen. Die Äquipotentiallinien 29 und 28 verlaufen, wie in Fig. 1 dargestellt, durch den Spalt zwischen den Feldplatten 11 und 12, die Äquipotentiallinien 27 und 26 durch den Spalt zwischen 12 und 13 usw.. Um den an sich stark gekrümmten Verlauf der Äquipotentiallinie 28 in der Nähe der Grenzfläche 1a in einen mehr geradlinigen Verlauf umzuformen, ist die Halbleiterzone 3 unterhalb des Teiles der Feldplatte 12, der sich von dem Kontaktloch 17 zum linken Plattenrand 12a erstreckt, mit einem lokalen Dotierungsmaximum versehen, was durch eine schraffierte Fläche 30 angedeutet ist. In analoger Weise wird der Verlauf der Äquipotentiallinie 26 durch ein weiteres lokales Dotierungsmaximum 31 der Halbleiterzone 3 begradigt. Entsprechendes gilt für die Äquipotentiallinie 24, deren Verlauf durch ein lokales Dotierungsmaximum 32 der Halbleiterzone 3 beeinflußt wird.

Der Verlauf der Äquipotentiallinien 21 bis 29 zeigt, daß es auch bei großen Werten von U an der Grenzfläche 1a in Bereichen des pn-Übergangs 4b, welche zwischen den Kontaktlöchern, z.B. 17, und den linken Feldplattenrändern, z.B. 12a, liegen, die Feldgradienten nicht so groß werden, daß die Gefahr eines Durchbruchs im Silizium besteht. Die erfindungsgemäße Struktur zeichnet sich dadurch aus, daß der laterale Spannungsabfall im Bereich zwischen der Grenzfläche 1a und dem pn-Übergang 4b gleichmäßig verläuft und dementsprechend auch innerhalb der Raumladungszone 21, 22 in der Nähe der Grenzfläche 1a eine relativ gleichmäßige Feldverteilung herrscht, obwohl die links von den zugeordneten Kontaktlöchern, z.B. 17, angeordneten Feldplattenränder, z.B. 12a, an sich Störungen des gleichmäßigen Feldverlaufs hervorrufen würden. Diese Störungen werden jedoch durch die Dotierungsmaxima, z. B. 30, der Halbleiterzone 3 weitgehend kompensiert. Die lateralen Maxima der Dotierungskonzentration, die etwa innerhalb der schraffierten Bereiche 30, 31 und 32 der Halbleiterzone 3 vorhanden sind, können z.B. um den Faktor 10 höher sein als die Werte der Dotierungskonzentration in den hieran angrenzenden Teilen der Zone 3. Die großflächige Abdeckung des Randbereiches des pn-Übergangs 4a, 4b durch die Feldplatten 11 bis 15, die nur schmale Spalte zwischen sich freilassen, bewirkt, daß die mit der erfindungsgemäßen Struktur erzielbare hohe Durchbruchspannung auch durch den Einfluß von z.B. wasserhaltigen Materialien, die zur Passivierung benutzt werden, nicht reduziert wird.

Die pn-Struktur nach Fig. 1 ist beispielsweise auch für vertikale bipolare Leistungstransistoren von Bedeutung. Einen solchen Transistor erhält man, wenn man ein n-leitendes Halbleitergebiet 33 so in das p-Halbleitergebiet 2 einfügt, daß es durch einen weiteren pn-Übergang 34 von diesem getrennt ist. 33 bezeichnet dann das Emittergebiet, 2 und 3 das Basisgebiet und 1 das Kollektorgebiet des Transistors. Die Elektroden 6 und 8 stellen die Kollektor- und Emitterelektrode dar, 7 und 9 den Kollektor- und Emitteranschluß. Das Basisgebiet 2 ist mit einer nicht dargestellten Basiselektrode versehen, die einen Anschluß für einen Basisstromkreis aufweist. Die mit der Erfindung erreichbare hohe Durchbruchspannung am Basis-Kollektor-Übergang 4a, 4b bewirkt eine hohe Spannungsfestigkeit dieses Transistors.

Fig. 2 zeigt die Anwendung der pn-Struktur nach Fig. 1 auf einen Thyristor. Das Gebiet 33 stellt hierbei den n-Emitter dar, das Gebiet 2 einschließlich der Zone 3 die p-Basis, der unterhalb von 4a und 4b liegende Teil des Halbleiterkörpers 1 die n-Basis und eine zusätzliche, p-dotierte Halbleiterschicht 35 an der Unterseite von 1 den p-Emitter des Thyristors. Die Elektrode 8 bedeutet die kathodenseitige Elektrode und eine die Schicht 35 kontaktierende Elektrode 36 die anodenseitige Elektrode des Thyristors. Die Anschlüsse von 8 und 36 werden hier mit K und A bezeichnet. Eine nicht dargestellte, das Gebiet 2 kontaktierende Elektrode bildet die Gateelektrode des Thyristors, die zum Zünden und/oder zum Löschen desselben mit Zünd- oder Löschsignalen beaufschlagt wird.

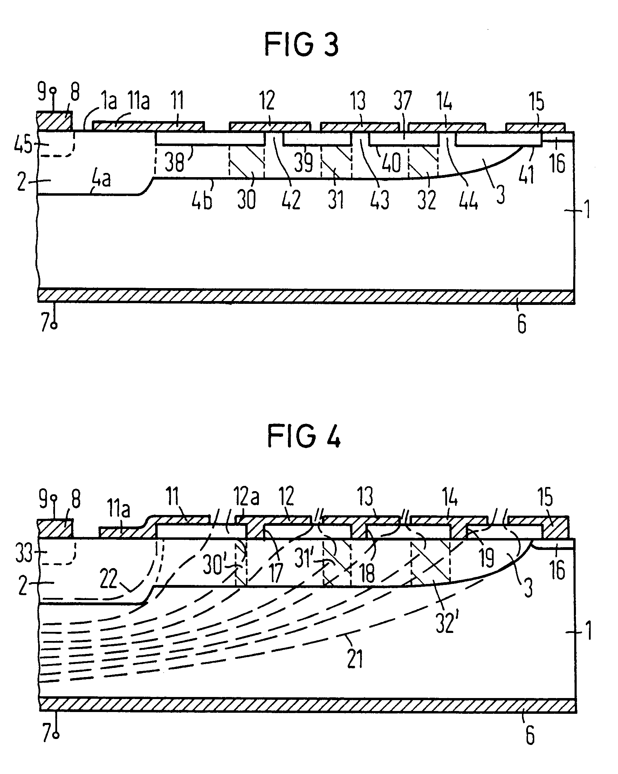

In Fig. 3 ist eine alternative strukturelle Ausgestaltung der Anordnung nach Fig. 1 dargestellt. Dabei sind die bereits anhand von Fig. 1 beschriebenen Strukturteile mit denselben Bezugszeichen versehen. Zum Unterschied von Fig. 1 ist hier eine elektrisch isolierende Schicht 37 vorgesehen, die nach dem Ausätzen von Ausnehmungen 38 bis 41 aus der Halbleiterzone 3 bzw. dem Halbleiterkörper 1 innerhalb derselben aufgewachsen wird. Die jeweils zwischen den Ausnehmungen 38 bis 41 verbleibenden, stegförmigen Teile 42 bis 44 der Halbleiterzone 3 werden von den auf die isolierende Schicht 37 aufgebrachten Feldplatten 12 bis 14 kontaktiert, während die Feldplatten 11 und 15 entsprechend Fig. 1 das Halbleitergebiet 2 und das Gebiet 16 kontaktieren. Der nicht gezeigte Verlauf der Äquipotentiallinien innerhalb der sich am pn-Übergang 4a, 4b beim Anlegen einer Sperrspannung aufbauenden Raumladungszone entspricht der Darstellung nach Fig. 1. Die Struktur nach Fig. 3 ist bei Einfügung eines n-leitenden Gebiets 45 in das Gebiet 2 auch für bipolare Transistoren von Bedeutung und bei entsprechender Anwendung auf Fig. 2 auch für Thyristoren.

Fig. 4 zeigt ein Ausführungsbeispiel der Erfindung, bei dem der Abstand der Kontaktlöcher, z.B. 17, von den Feldplattenrändern, z.B. 12a, nicht konstant ist, sondern von Feldplatte zu Feldplatte variiert. Im einzelnen sind die innerste und die äußerste Feldplatte 11 bzw. 15 in gleicher Weise ausgebildet wie in Fig. 1, während die Abstände der Kontaktlöcher der Feldplatten 12 bis 14 von den jeweiligen linken Plattenrändern von einem relativ kleinen Wert bei der Feldplatte 12 bis zu einem relativ großen Wert bei der Feldplatte 14 ansteigen. Das Kontaktloch 17 weist jedoch auch hier einen deutlichen Abstand vom linken Plattenrand 12a auf, ebenso wie das Kontaktloch 19 vom rechten Plattenrand der Feldplatte 14. Entsprechend den unterschiedlichen Längen der sich jeweils links von den zugeordneten Kontaktlöchern befindenden Plattenteile weisen die Bereiche der lokalen Dotierungsmaxima 30′, 31′ und 32′ in der p-dotierten Halbleiterzone unterschiedliche Breiten auf. Die Äquipotentiallinien 21, 22 und die dazwischenliegenden Äquipotentiallinien haben etwa den gleichen Verlauf wie in Fig. 1. Die Struktur nach Fig. 4 kann insbesondere eine kleinere Eindringtiefe der Halbleiterzone 3 aufweisen als die Struktur nach Fig. 1.

Die dargestellten Ausführungsbeispiele des pn-Übergangs nach der Erfindung sind vorzugsweise auf rotationssymmetrischen Halbleiterkörpern, d.h. Halbleiterscheiben mit kreisförmigen lateralen Begrenzungen, realisiert. Dabei weisen auch die Teile 2, 3, 33 und 45 kreisförmige laterale Begrenzungen auf, während die Feldplatten 11 bis 15 die Form von Kreisringen haben.

Neben den bisher beschriebenen Ausführungsformen gehören auch solche zur Erfindung, bei denen die genannten Halbleitergebiete jeweils durch solche des entgegengesetzten Leitfähigkeitstyps ersetzt sind, wobei anstelle der genannten Spannung U eine Spannung des entgegengesetzten Vorzeichens verwendet wird.

## Patentansprüche

1. Planarer pn-Übergang (4a, 4b) hoher Spannungsfestigkeit, der im wesentlichen parallel zur Grenzfläche (1a) eines dotierten Halbleiterkörpers (1) eines ersten Leitfähigkeitstyps verläuft und ein in diesen eingefügtes Halbleitergebiet (2) eines zweiten Leitfähigkeitstyps von dem übrigen Teil des Halbleiterkörpers (1) trennt, wobei eine Mehrzahl von Feldplatten (11 bis 15) im Randbereich des Halbleitergebiets (2) vorgesehen sind, die durch eine elektrisch isolierende Schicht (10) von der Grenzfläche (1a) getrennt sind und den Halbleiterkörper jeweils im Bereich eines Kontaktloches (17 bis 19) dieser Schicht (10) kontaktieren, **dadurch gekennzeichnet,** daß zumindest bei einem Teil der Feldplatten (12 bis 14) mit Ausnahme der innersten (11) und äußersten (15) die Anordnung der Kontaktlöcher (17) so getroffen ist, daß sie jeweils einen Abstand vom inneren Feldplattenrand (12a) aufweisen, der ihrem Abstand vom äußeren Feldplattenrand (12b) entspricht, unterschreitet oder überschreitet, wobei das Maß der Unterschreitung oder Überschreitung nur so groß ist, daß die Kontaktlöcher (17) noch einen deutlichen Abstand vom inneren (12a) und äußeren Feldplattenrand (12b) aufweisen, daß das Halbleitergebiet (2) durch eine unterhalb der Feldplatten (11 bis 15) liegende Halbleiterzone (3) des zweiten Leitfähigkeitstyps mit planarem Randabschluß in lateraler Richtung verlängert ist, deren Dotierungsgrad wesentlich kleiner ist als der des Halbleitergebiets (2), und daß der Dotierungsgrad der Halbleiterzone (3) in lateraler Richtung in seiner Größe variiert, wobei er jeweils unterhalb der Feldplattenteile, die zwischen den Kontaktlöchern (17) und den inneren Rändern (12a) gehörigen Feldplatten (12) liegen, lokale Maxima (30) aufweist.

2. Planarer pn-Übergang nach Anspruch 1, **dadurch gekennzeichnet,** daß die elektrisch isolierende Schicht (37) aus einer Mehrzahl von Teilschichten besteht, die innerhalb von einer Mehrzahl von oberflächenseitigen Ausnehmungen (38 bis 41) der Halbleiterzone (3) vorgesehen sind, daß zwischen jeweils zwei solchen, einander benachbarten Ausnehmungen (38, 39) ein sich bis an die Grenzfläche (1a) erstreckender Steg (42) der Halbleiterzone (3) vorhanden ist, der zur Kontaktierung einer Feldplatte (12) dient, die auf den in den beiden benachbarten Ausnehmungen (38, 39) befindlichen Teilschichten aufgebracht ist, und daß die an den Steg (42) angrenzenden Ränder der Teilschichten, die in den benachbarten Ausnehmungen (38, 39) vorgesehen sind, das dieser Feldplatte (12) zugeordnete Kontaktloch zwischen sich begrenzen.

3. Planarer pn-Übergang nach Anspruch 1 oder 2, **dadurch gekennzeichnet,** daß die Abstände der Kontaktlöcher (17) von den inneren Feldplattenrändern (12a) der ihnen jeweils zugeordneten Feldplatten (12) mit wachsender Entfernung der Feldplatten (12) vom Rand des Halbleitergebiets (2) ansteigen.

## Claims

1. Planar p-n junction (4a, 4b) which has high voltage sustaining capability and which extends essentially parallel to the boundary surface (1a) of a doped semiconductor body (1) of a first conductivity type and separates a semiconductor region (2), inserted in said semiconductor body (1), of a second conductivity type from the rest of the semiconductor body (1), a plurality of field plates (11 to 15) which are separated by an electrically isolating layer (10) from the boundary surface (1a) and contact the semiconductor body in each case in the region of a via (17 to 19) in said layer (10) being provided in the peripheral region of the semiconductor region (2), characterized in that, at least in the case of some of the field plates (12 to 14) with the exception of the innermost (11) and the outermost (15), the vias (17) are arranged so that in each case they are at a distance from the inner field-plate periphery (12a), which distance is equal to, falls below or exceeds their distance from the outer field-plate periphery (12b), the degree to which it falls below or exceeds only being large enough for the vias (17) still to be at a perceptible distance from the inner field-plate periphery (12a) and outer field-plate periphery (12b), in that the semiconductor region (2) is extended in the lateral direction by a semiconductor zone (3) which is situated underneath the field plates (11 to 15), is of the second conductivity type and has planar peripheral termination and whose degree of doping is substantially less than that of the semiconductor region (2), and in that the degree of doping of the semiconductor zone (3) varies in its magnitude in the lateral direction, having in each case local maxima (30) underneath the field-plate components which are situated between the vias (17) and the field plates (12) associated with the inner peripheries (12a).

2. Planar p-n junction according to Claim 1, characterized in that the electrically insulating layer (37) comprises a plurality of sublayers which are provided in a plurality of superficial recesses (38 to 41) of the semiconductor zone (3), in that there is present, between each two mutually adjacent recesses (38, 39) of this type, a fillet (42) of the semiconductor zone (3), which fillet extends up to the boundary surface (1a) and serves to contact a field plate (12) which is deposited on the sublayers situated in the two adjacent recesses (38, 39), and in that the peripheries, adjacent to the fillet (42) of the sublayers which are provided in the adjacent recesses (38, 39) form the boundary between them of the via allocated to said field plate (12).

3. Planar p-n junction according to Claim 1 or 2, characterized in that the distances of the vias (17) from the inner field-plate peripheries (12a) of the field plates (12) allocated to them in each case increase with increasing distance of the field plates (12) from the periphery of the semiconductor region (2).

## Revendications

1. Jonction pn planar (4a, 4b) à grande rigidité diélectrique, qui s'étend essentiellement parallèlement à la surface limite (1a) d'un corps semiconducteur dopé (1) d'un premier type de conductivité, et qui sépare une région semiconductrice (2), insérée dans ce corps, d'un second type de conductivité, du reste du corps semiconducteur (1), un grand nombre de magnétorésistances (11 à 15) étant prévues dans la zone marginale de la région semiconductrice (2), ces magnétorésistances étant séparées de la surface limite (1a) par une couche électriquement isolante (10) et établissant un contact avec le corps semiconducteur dans la zone d'un trou de contact (17 à 19) de cette couche (10), caractérisée par le fait qu'au moins dans une partie des magnétorésistances (12 à 14), à l'exception de la magnétorésistance la plus intérieure (11) et de la magnétorésistance la plus extérieure (15), la disposition des trous de contact (17) est telle qu'ils sont situés à une distance du bord intérieur (12a) de la magnétorésistance, qui correspond, qui est inférieure ou qui est supérieure à leur distance par rapport au bord extérieur (12b) de la magnétorésistance, le degré de dépassement par valeur inférieure ou supérieure étant juste suffisant pour que les trous de contact (17) soient encore situés à une distance nette du bord intérieur (12a) et du bord extérieur(12b) de la magnétorésistance, que la région semiconductrice (2) est prolongée, dans une direction latérale, par une zone semiconductrice (3) du second type de conductivité qui est située en-dessous des magnétorésistances (11 à 15), et qui comporte une terminaison marginale planar et dont le degré de dopage est nettement inférieur à celui de la région semiconductrice (2), et que la valeur du degré de dopage de la zone semiconductrice (3) varie dans la direction latérale, en présentant des maxima locaux (30) en-dessous des parties des magnétorésistances, qui sont situées entre les trous de contact (17) et les bords intérieurs (12a)des magnétorésistance (12) associées.

2. Jonction pn planar suivant la revendication 1, caractérisée par le fait que la couche électriquement isolante (37) est constituée d'une multiplicité de couches partielles, qui sont prévues à l'intérieur d'une multiplicité d'évidements surfaciques (38 à 41) de la zone semiconductrice (3), qu'entre deux évidements (38, 39) de ce type, voisins l'un de l'autre, est prévue une barrette (42) de la zone semiconductrice (3), qui s'étend jusqu'à la surface limite (1a) et qui sert à établir le contact avec une magnétorésistance (12), qui est disposée sur les couches partielles situées dans les évidements voisins (38, 39), et que les bords, qui jouxtent la barrette (42), des couches partielles qui sont prévues dans les évidements voisins (38, 39), limitent entre eux le trou de contact associé à cette magnétorésistance (12).

3. Jonction pn planar suivant la revendication 1 ou 2, caractérisé par le fait que les distances entre les trous de contact (17) et les bords intérieurs (12a) des magnétorésistances (12) qui leur sont associées, augmentent avec l'augmentation de la distance entre les magnétorésistances (12) et le bord de la région semiconductrice (2).
